# EUROPEAN PATENT SPECIFICATION

(11) **EP 2 775 732 B1**
(45) Date of publication and mention of the grant of the patent: **03.02.2016**
(21) Application number: 13158429.4
(22) Date of filing: 08.03.2013
(51) Int. Cl.: H04Q 1/14, H05K 3/30

(54) **Protection device for a contact strip of a distribution device**
Schutzvorrichtung für einen Kontaktstreifen einer Verteilervorrichtung
Dispositif de protection pour une bande de contact d'un dispositif de distribution

(43) Date of publication of application: 10.09.2014
(73) Proprietor: CCS Technology, Inc., Wilmington, DE 19803 (US)
(72) Inventor: Sauer, Marc, Dipl.-Ing., 58640 Iserlohn (DE); Roettger, Theodor, 59457 Werl (DE)
(74) Representative: Sturm, Christoph

(56) References cited:
- EP-A2- 1 983 809
- US-A- 4 331 839
- US-A1- 2010 285 693

## Description

The present disclosure generally relates to a protection device for a contact strip of a telecommunication distribution device and to a telecommunication distribution device.

The product catalogue "Connection and Distribution Systems, Edition 1, Corning Cable Systems GmbH & Co KG, page 19, year 2000" discloses a distribution device in form a of a MDF (main distribution frame) block pertaining to telecommunication installations. Such a MDF block comprises a mounting frame, a plurality of MDF contact strips (also called functional elements) accommodated in the mounting frame, a plurality of wire guides accommodated in the mounting frame and a plurality of protection devices accommodated in the mounting frame. Each protection device is contacted to a MDF contact strip. The protection devices provide overvoltage protection or overvoltage and overcurrent protection for the MDF contact strips. The present disclosure relates to details of such protection devices. The above product catalogue "Connection and Distribution System, Edition 1, Corning Cable Systems GmbH & Co, KG, page 30, year 2000" further discloses details of prior art protection devices.

Such protection devices used in MDF blocks must comply with standardized tests. One test which has to be fulfilled is the so-called "mains power contact test" (also called "power cross test"), in which a distribution device including a protection device is applied to the mains power (e.g. 230 V, 50 Hz) for a defined period of time (e.g. 15 minutes). The test severity can be different and is defined by a test resistor, whereas the highest severity is under use of a 10 Ω test resistor. The use of a 10 Ω test resistor results in a high electrical current flow through the protection device. Depending upon the test criteria no fire hazard can arise and/or the damage caused by the test should be confined to a small part of the protection device.

At this time there is no protection device based on a printed circuit board (PCB) which passes the power cross test at its highest severity. Either the printed circuit board (PCB) of the protection device overheat, which results in severe fire hazard, or arresters in form of a gas discharge tube (GTD) become so hot that they de-solder from the PCB, and melt through the plastic housing covering the arresters.

US 2010/285693 A1 discloses a protection device according to the preamble of claim 1.

EP 1 983 809 A2 discloses a printed circuit board with resistors having lead wired with bent ends. The bent ends act together with non-conductive areas.

The present disclosure relates to providing a novel protection device for contact strips that pass the power cross test at its highest severity.

The protection device is simple and ensures that the protection device reliably fulfills the power cross test at its highest severity. Even if the arresters would become de-soldered, the bent ends of the bent lead wires would hold the arresters at the printed circuit board so that the same cannot come into contact with a plastic housing covering the arresters thereby avoiding that the arresters melt through the plastic housing.

According to another embodiment, each contacting zone has a surface between 5 mm² and 12 mm², each insulating zone surrounding the respective contacting zone has a width between 0.8 mm and 2 mm, and the grounding layer has a surface in between 1000 mm² and 2400 mm², preferably between 1000 mm² and 1800 mm². These dimensions of the contacting zones, of the insulating zones and of the grounding layer provide improved properties of the protection device. Overheating of the printed circuit board (PCB) can be avoided even under high electrical current flows. In addition, the risk of de-soldering the arresters from the PCB can be minimized.

Embodiments of the protection device are given in the description below. Exemplary embodiments will be explained in more detail with reference to the drawings, in which:
- Figure 1: shows a top view of a protection device for a contact strip of a telecommunication distribution device, the protection device comprising a printed circuit board, arresters, a housing and grounding springs;
- Figure 2: shows a bottom view of the protection device of Figure 1 with the housing and grounding springs being removed;

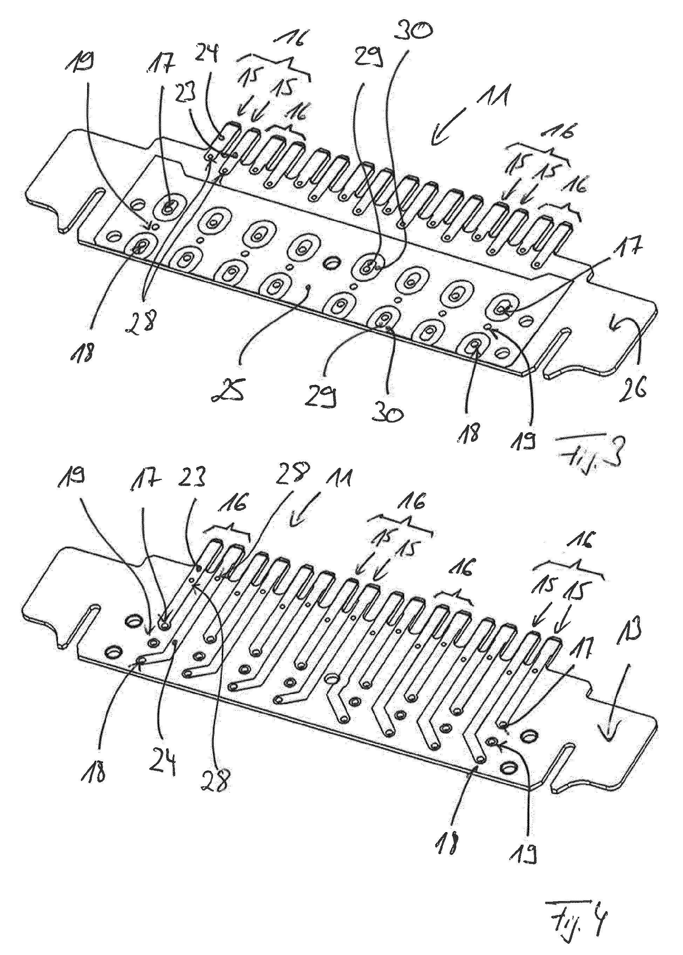

- Figure 3: shows a top view of the printed circuit board of the protection device of Figure 1; and
- Figure 4: shows a bottom view of the printed circuit board of Figure 3.

The present patent application relates to a contact strip of a telecommunication distribution device like a main distribution frame (MDF) block and to a telecommunication distribution device comprising such a protection device.

A protection device 10 comprises a printed circuit board 11 and a plurality of arresters 12 mounted on the printed circuit board 11. In the illustrated embodiment, the arresters 12 are gas discharge tubes. The arresters 12 are mounted on a bottom side 13 of the printed circuit board 11 and are covered by a housing 14. The housing 14 is preferably made from a plastic material.

The printed circuit board 11 provides contact blades 15 thorough which the protection device 10 is connectable to contact springs of the contact strip. The contact blades 15 of the printed circuit board 11 are arranged side-by-side as a plurality of contact blade pairs 16.

In the shown embodiment, the printed circuit board 11 comprises sixteen contact blades 15 arranged as eight contact blade pairs 16. The contact blades 15 of each contact blade pair 16 are connectable with contact springs of contact spring pairs of the contact strip.

To each contact blade pair 16 there is assigned an arrester 12 in such a way that the respective arrester 12 is electrically connected with the contact blades 15 of the respective contact blade pair 16 by electrical conductive paths 23, 24.

The electrical conductive paths 23, 24 are located on the printed circuit board 11. The electrical conductive paths 23, 24 extend substantially only on the bottom side 13 of the printed circuit board 11. In the region of the contact blades 15, the electrical conductive paths 23, 24 are extend on the top side 26 of the printed circuit board 11. Segments of the electrical conductive paths 23, 24 disposed on the top side 26 of the contact blades 15 contact segments of the conductive paths 23, 24 located on the bottom side 13 of the contact blades 15 by through hole connections 28 extending through the printed circuit board 11 between the bottom side 13 and the top side 26 of the printed circuit board 11.

The printed circuit board 11 further includes through holes 17, 18, 19 for receiving lead wires 20, 21, 22 of the arresters 12. The electrical conductive paths 23, 24 extend between the contact blades 15 and first and second through holes 17, 18 for receiving first and second lead wires 20, 21 of the arresters 12. Each of the electrical conductive paths 23 extend between a first through hole 17 and a first contact blade 15 of the respective contact blade pair 16, and each of the electrical conductive paths 24 extend between the second through hole 18 and a second contact blade 15 of the respective contact blade pair 16.

The electrical conductive paths 23, 24 assigned to a contact blade pair 16 are in electrical contact with each other through the arrester 12 assigned to a contact blade pair 16 when the first and second lead wires 20, 21 of the respective arrester 12 are accommodated within the first and second through holes 17, 18.

Each arrester 12 comprises in addition to the first and second lead wires 20, 21 a third lead wire 22 that is electrically connected to a grounding layer 25 of the printed circuit board 11. The third lead wire 22 of each arrester 12 is accommodated by a third through hole 19 of the printed circuit board 11. The grounding layer 25 is located on the top side 26 of the printed circuit board 11.

The lead wires 20, 21, 22 of the arresters 12 are soldered to the printed circuit board 11 in the region of the through holes 17, 18, 19. The through holes 17, 18, 19 are preferably plated drill holes providing a through contact between the two sides of the printed circuit board.

On both sides of the protection device 10 grounding springs 27 are mounted to the printed circuit board 11 so that the same are in electrical contact with the grounding layer 25. When the protection device 10 is accommodated in a mounting frame of a MDF block the grounding springs 27 provide an electrically conductive path between the grounding layer 25 of the protection device 10 and the mounting frame of the MDF block.

The grounding springs 27 are mounted to the printed circuit board 11 by fastening means such as rivets 31, wherein the grounding springs 27 are in electrical contact with the grounding layer 25. The rivets 31 are further used to mount the housing 14 to the printed circuit board 11.

At least the first and second lead wires 20, 21 of each arrester 12 are bent in such a way that bent ends of the lead wires 20, 21 of the arresters 12 extend on one top side 26 of the printed circuit board 11 in parallel to a plane defined by the printed circuit board 11.

Even if arresters 12 become de-soldered, the bent ends of the lead wires 20, 21 will hold the arresters 12 at the printed circuit board 11 so that the arresters 12 cannot come into contact with the housing 14, thereby preventing the arresters 12 from melting through the plastic housing 14.

It is also possible that the third lead wires 22 of the arresters 12 comprise such bent ends.

The bent ends of the bent lead wires 20, 21 of the arresters 12 run in the region of the top side 26 of the printed circuit board 11 in parallel to a plane defined by the printed circuit board 11. The bent end of each bent lead wire 20, 21 is in electrical contact each with a contacting zone 29 provided on the top side 26 of the printed circuit board 11. The contacting zones 29 are positioned in the same plane as the grounding layer 25. The first and second through holes 17, 18 extend through the respective contacting zone 29 offset from the center of the respective contacting zone 29.

Each of the contacting zones 29 is separated from the grounding layer 25 by an insulating zone 30 surrounding the respective contacting zone 29.

The through holes 17, 18 provide a through contact between the two sides of the printed circuit board 11, namely between the electrical conductive paths 23, 24 provided on the bottom side 13 of the printed circuit board 11 and the contacting zones 29 provided on the top side 16 of the printed circuit board 11.

The through holes 19 provide also a through contact between the two sides of the printed circuit board 11, namely from the bottom side 13 of the printed circuit board 11 to grounding layer 25 provided on the top side 16 of the printed circuit board 11.

Each contacting zone 29 has a surface between 5 mm² and 12 mm², preferably a surface between 5 mm² and 9 mm². This ensures a good electrical contact of the bend ends of the bent lead wires 20, 21 with the respective contacting zone 29 and minimizes the risk of de-soldering the arresters 12.

Each insulating zone 30 surrounding the respective contacting zone 29 has a width between 0.8 mm and 2 mm, preferably a width between 1 mm and 1.5 mm. Each insulating section zone 30 has a surface between 10 mm² and 60 mm², preferably a surface between 20 mm² and 50 mm². This ensures a good electrical insulation between of each contacting zone 29 and the grounding layer 25.

The grounding layer 25 has a surface between 1000 mm² and 2400 mm², preferably a surface between 1000 mm² and 1800 mm². This minimizes the risk of overheating of the printed circuit board 11 even under high electrical current flows. The grounding layer 25 can effectively distribute heat dissipation of the arresters 12.

A contacting area between the grounding layer 25 and each of the grounding springs has a surface between 100 mm² and 200 mm².

The grounding layer 25, the contacting zones 29 and the electrical conductive paths 23, 24 are preferably made from copper having a thickness between 100 µm and 150 µm, preferably between 120 µm and 135 µm. This thickness further supports an effective heat distribution.

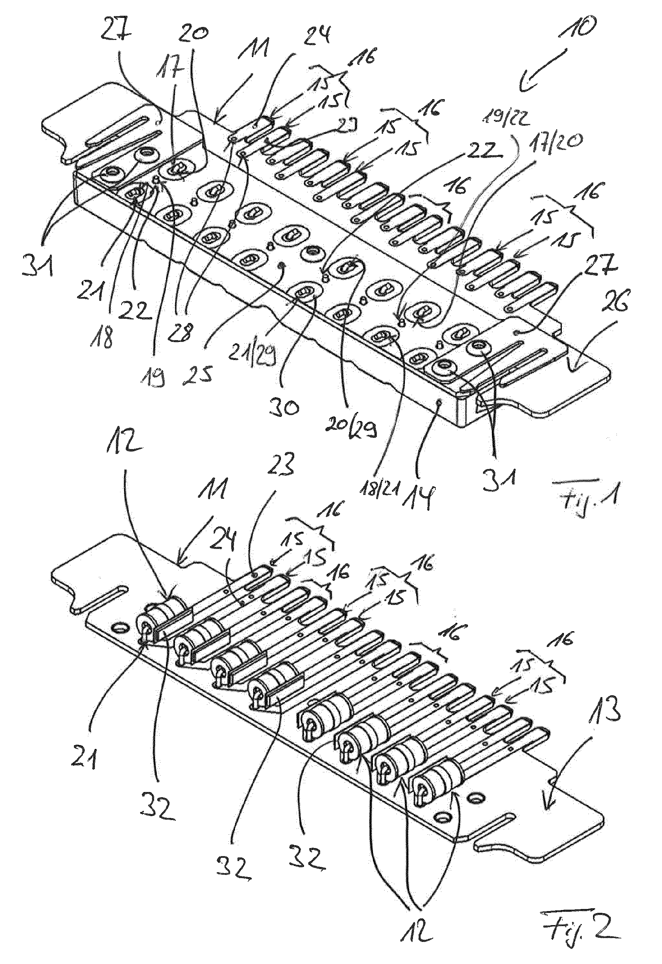

Figure 2 shows that fail-safe elements 32 are assigned to the arresters 12. The fail fail-safe elements 32 are provided by foil elements. The foil elements begin to melt at temperatures of greater than 260 °C. Once an arrester 12 is shorted by fail-safe element 32, the electrical current is flowing through the arrester 12 to the ground layer 25.

The protection device 10 according to the present disclosure is capable to pass the power cross test at its highest severity. When running the a power cross test, a distribution device including a protection device is applied to the mains power of 230 V, 50 Hz for a defined period of time of 15 minutes. The test severity can be different and is defined by a test resistor, where the highest severity is when using a 10 Ω test resistor. This test results in an electrical current flow of 23 Amp (A) per lead wire 20, 21 to ground, which means that in total an electrical current of 46 A is flowing through the ground connection of each arrester 12.

Even at such conditions the protection device 10 according to the present disclosure reduces the overheating risk of the printed circuit board 11. Accordingly, the risk of de-soldering of the arresters 12 from the printed circuit board PCB 11 is also reduced.

If the arresters 12 should become de-soldered, the bent ends of the bent lead wires 20, 21 would hold the arresters 12 at the printed circuit board 11 so that the arresters cannot come into contact with a plastic housing 14 covering the arresters 12, thereby preventing the arresters 12 from melting through the plastic housing 14.

As discussed above, the bent lead wires 20, 21 of the arresters 12 fix the arresters 12 properly to the solder side of the printed circuit board 11 even though if the solder is melted. The contacting zones 29 ensure a good electrical contact of the lead wires 20, 21 with the contacting zones 29 and ensure that molten solder won't run down lead wires 20, 21. The grounding layer 25 distributes a lot of the heat power emitting from the arresters 12. The heat sink provided by the grounding layer 25 supports operation of the device 10 by reducing the temperature of the printed circuit board 11.

The protection device 10 according to the present disclosure can be designed as a so-called overvoltage protection device or a so-called overvoltage and overcurrent protection device. An overvoltage and overcurrent protection device comprises in addition to the arresters 12 PTC (positive temperature coefficient) elements acting as current-dependent switches.

The present disclosure further relates to a telecommunication distribution device like to an MDF block. Such a telecommunication distribution device comprises a mounting frame, a plurality of contact strips accommodated in the mounting frame, a plurality of wire guides accommodated in the mounting frame and a plurality of protection devices accommodated in the mounting frame, wherein each protection device is connected with a contact strip, and wherein at least one protection device is designed as discussed above.

### List of reference numerals

- 10: protection device
- 11: printed circuit board
- 12: arrester
- 13: bottom side
- 14: housing
- 15: contact blade
- 16: contact blade pair
- 17: through hole
- 18: through hole
- 19: through hole
- 20: lead wire
- 21: lead wire
- 22: lead wire
- 23: electrical conductive path
- 24: electrical conductive path
- 25: grounding layer
- 26: top side
- 27: grounding spring
- 28: through hole connection
- 29: contacting zone
- 30: insulating zone
- 31: rivet
- 32: fail-safe element

## Claims

1. A protection device (10) for a contact strip of a telecommunication distribution device comprising a printed circuit board (11) and a plurality of arresters (12) mounted on the printed circuit board (11),
wherein the printed circuit board (11) provides contact blades (15) through which the protection device (10) is connectable to contact springs of the contact strip, the contact blades (15) being arranged side-by-side as a plurality of contact blade pairs (16);
wherein the printed circuit board (11) provides through holes (17, 18, 19) for receiving lead wires (20, 21, 22) of the arresters (12);
wherein to each contact blade pair (16) there is assigned an arrester (12), wherein the respective arrester (12) is in electrical contact with the contact blades (15) of the respective contact blade pair (16),
**characterized in that**
each arrester (12) comprises at least three lead wires (20, 21, 22), namely first and second lead wires (20, 21) being electrically connected with the contact blades (15) of the respective contact blade pair (16) and a third lead wire (22) being electrically connected to a grounding layer (25) of the printed circuit board (11),
electrical conductive paths (23, 24) extending between the contact blades (15) and first and second through holes (17, 18) for receiving the first and second lead wires (20, 21) of the arresters (12) are located on a first side (13) of the printed circuit board (11) while the grounding layer (25) is located on an opposite second side (26) of the printed circuit board (11),
at least the first and second lead wires (20, 21) of each arrester (12) are bent, wherein bent ends of the bent lead wires (20, 21) of the arresters (12) extend on the second side (26) of the printed circuit board (11) in parallel to a plane defined by the printed circuit board (11),
the bent end of each bent lead wire (20, 21) is in electrical contact each with a contacting zone (29) provided on the second side (26) of the printed circuit board (11), wherein each of the contacting zones (29) is separated from the grounding layer (25) by an insulating zone (30) surrounding the respective contacting zone (29),
the first and second through holes (17, 18) provide through contact between the electrical conductive paths (23, 24) provided on the first side (13) of the printed circuit board (11) and the contacting zones (29) provided on the second side (16) of the printed circuit board (11).

2. The protection device of claim 1, **characterized in that** electrical conductive paths (23, 24) provided by the printed circuit board (11) extend between the contact blades (15) and first and second through holes (17, 18) for receiving first and second lead wires (20, 21) of the arresters, wherein the electrical conductive paths (23, 24) being assigned to a contact blade pair (16) are in electrical contact with each other when the first and second lead wires (20, 21) of the arrester (12) being assigned to said contact blade pair (16) are accommodated within the first and second through holes (17, 18).

3. The protection device of claim 2, **characterized in that** the electrical conductive paths (23, 24) extending between the contact blades (15) and first and second through holes (17, 18) are located on a bottom side (13) of the printed circuit board (11).

4. The protection device of claim 3, **characterized in that** the bent ends of the bent lead wires (20, 21) of the arresters (12) extend on a top side (26) of the printed circuit board (11) in parallel to a plane defined by the printed circuit board (11).

5. The protection device of one of claims 2 to 4, **characterized in that** only in the region of the contact blades (15) the electrical conductive paths (23, 24) extending between the contact blades (15) and first and second through holes (17, 18) are located on both sides (13, 16) of the printed circuit board (11), namely in such a way that sections of the conductive paths (23, 24) running on the opposite sides of the contact blades (15) are connected by though hole connections (28).

6. The protection device of one of claims 1 to 5, **characterized in that** each contacting zone (29) has a surface between 5 mm² and 12 mm², preferably between 5 mm² and 9 mm².

7. The protection device of one of claims 1 to 6, **characterized in that** each insulating zone (30) surrounding the respective contacting zone (29) has a width between 0.8 mm and 2 mm, preferably between 1,0 mm and 1,5 mm.

8. The protection device of one of claims 1 to 7, **characterized in that** each insulating section zone (30) has a surface between 10 mm² and 60 mm², preferably between 20 mm² and 50 mm².

9. The protection device of one of claims 1 to 8, **characterized in that** the grounding layer (25) has a surface between 1000 mm² and 2400 mm², preferably between 1000 mm² and 1800 mm².

10. The protection device of one of claims 1 to 9, **characterized in that** grounding layer (25), the contacting zones (29) and the electrical conductive paths (23, 24) are preferably made from copper having a thickness between 100 µm and 150 µm, preferably between 120 µm and 135 µm.

11. A telecommunication distribution device, comprising
a mounting frame,
a plurality of contact strips accommodated in the mounting frame,
a plurality of protection devices accommodated in the mounting frame, each protection device being connected with a contact strip,
**characterized in that**
at least one protection device is provided by protection device of one of claims 1 to 10.

## Patentansprüche

1. Schutzvorrichtung (10) für einen Kontaktstreifen einer Telekommunikationsverteilervorrichtung, die eine gedruckte Leiterplatte (11) und mehrere Ableiter (12) umfasst, die an der gedruckten Leiterplatte (11) befestigt sind,
wobei die gedruckte Leiterplatte (11) Kontaktblätter (15) bereitstellt, durch die die Schutzvorrichtung (10) mit Kontaktfedern des Kontaktstreifens verbindbar ist, wobei die Kontaktblätter (15) nebeneinander als mehrere Kontaktblätterpaare (16) angeordnet sind;
wobei die gedruckte Leiterplatte (11) Durchgangslöcher (17, 18, 19) zum Aufnehmen von Zuleitungsdrähten (20, 21, 22) der Ableiter (12) bereitstellt;
wobei jedem Kontaktblätterpaar (16) ein Ableiter (12) zugeordnet ist, wobei der jeweilige Ableiter (12) mit den Kontaktblättern (15) des jeweiligen Kontaktblätterpaars (16) in elektrischem Kontakt steht,
**dadurch gekennzeichnet, dass**
jeder Ableiter (12) mindestens drei Zuleitungsdrähte (20, 21, 22) umfasst, nämlich den ersten und den zweiten Zuleitungsdraht (20, 21), die mit den Kontaktblättern (15) des jeweiligen Kontaktblätterpaars (16) elektrisch verbunden sind, und einen dritten Zuleitungsdraht (22), der mit einer Erdungsschicht (25) der gedruckten Leiterplatte (11) elektrisch verbunden ist,
elektrisch leitfähige Bahnen (23, 24), die sich zwischen den Kontaktblättern (15) und einem ersten und einem zweiten Durchgangsloch (17, 18) zur Aufnahme des ersten und zweiten Zuleitungsdrahts (20, 21) der Ableiter (12) erstrecken, auf einer ersten Seite (13) der gedruckten Leiterplatte (11) angeordnet sind, während die Erdungsschicht (25) auf einer gegenüberliegenden zweiten Seite (26) der gedruckten Leiterplatte (11) angeordnet ist,
mindestens der erste und der zweite Zuleitungsdraht (20, 21) jedes Ableiters (12) gebogen sind, wobei sich gebogene Enden der gebogenen Zuleitungsdrähte (20, 21) der Ableiter (12) auf der zweiten Seite (26) der gedruckten Leiterplatte (11) parallel zu einer Ebene erstrecken, die durch die gedruckte Leiterplatte (11) definiert ist,
das gebogene Ende jedes gebogenen Zuleitungsdrahtes (20, 21) jeweils mit einem Kontaktbereich (29) in elektrischem Kontakt steht, der auf der zweiten Seite (26) der gedruckten Leiterplatte (11) bereitgestellt ist, wobei jeder der Kontaktbereiche (29) von der Erdungsschicht (25) durch einen Isolierbereich (30) getrennt ist, der den jeweiligen Kontaktbereich (29) umgibt,
das erste und das zweite Durchgangsloch (17, 18) zwischen den elektrisch leitfähigen Bahnen (23, 24), die auf der ersten Seite (13) der gedruckten Leiterplatte (11) bereitgestellt sind, und den Kontaktbereichen (29), die auf der zweiten Seite (16) der gedruckten Leiterplatte (11) bereitgestellt sind, einen Durchgangskontakt bereitstellen.

2. Schutzvorrichtung nach Anspruch 1, **dadurch gekennzeichnet, dass** sich elektrisch leitfähige Bahnen (23, 24), die von der gedruckten Leiterplatte (11) bereitgestellt werden, zwischen den Kontaktblättern (15) und einem ersten und einem zweiten Durchgangsloch (17, 18) erstrecken, um einen ersten und einen zweiten Zuleitungsdraht (20, 21) der Ableiter aufzunehmen, wobei die elektrisch leitfähigen Bahnen (23, 24), die einem Kontaktblätterpaar (16) zugeordnet sind, miteinander in elektrischem Kontakt stehen, wenn der erste und der zweite Zuleitungsdraht (20, 21) des Ableiters (12), der dem Kontaktblätterpaar (16) zugeordnet ist, in dem ersten und dem zweiten Durchgangsloch (17, 18) untergebracht sind.

3. Schutzvorrichtung nach Anspruch 2, **dadurch gekennzeichnet, dass** die elektrisch leitfähigen Bahnen (23, 24), die sich zwischen den Kontaktblättern (15) und dem ersten und dem zweiten Durchgangsloch (17, 18) erstrecken, auf einer Unterseite (13) der gedruckten Leiterplatte (11) angeordnet sind.

4. Schutzvorrichtung nach Anspruch 3, **dadurch gekennzeichnet, dass** sich die gebogenen Enden der gebogenen Zuleitungsdrähte (20, 21) der Ableiter (12) auf einer Oberseite (26) der gedruckten Leiterplatte (11) parallel zu einer Ebene erstrecken, die durch die gedruckte Leiterplatte (11) definiert ist.

5. Schutzvorrichtung nach einem der Ansprüche 2 bis 4, **dadurch gekennzeichnet, dass** sich nur in der Region der Kontaktblätter (15) die elektrisch leitfähigen Bahnen (23, 24), die sich zwischen den Kontaktblättern (15) und dem ersten und dem zweiten Durchgangsloch (17, 18) erstrecken, auf beiden Seiten (13, 16) der gedruckten Leiterplatte (11) angeordnet sind, und zwar derart, dass Abschnitte der leitfähigen Bahnen (23, 24), die auf den gegenüberliegenden Seiten der Kontaktblätter (15) verlaufen, durch Durchgangslochverbindungen (28) verbunden sind.

6. Schutzvorrichtung nach einem der Ansprüche 1 bis 5, **dadurch gekennzeichnet, dass** jeder Kontaktbereich (29) eine Oberfläche zwischen 5 mm² und 12 mm², vorzugsweise zwischen 5 mm² und 9 mm² aufweist.

7. Schutzvorrichtung nach einem der Ansprüche 1 bis 6, **dadurch gekennzeichnet, dass** jeder Isolierbereich (30), der den jeweiligen Kontaktbereich (29) umgibt, eine Breite zwischen 0,8 mm und 2 mm, vorzugsweise zwischen 1,0 mm und 1,5 mm aufweist.

8. Schutzvorrichtung nach einem der Ansprüche 1 bis 7, **dadurch gekennzeichnet, dass** jeder Isolierabschnittsbereich (30) eine Oberfläche zwischen 10 mm² und 60 mm², vorzugsweise zwischen 20 mm² und 50 mm² aufweist.

9. Schutzvorrichtung nach einem der Ansprüche 1 bis 8, **dadurch gekennzeichnet, dass** die Erdungsschicht (25) eine Oberfläche zwischen 1000 mm² und 2400 mm², vorzugsweise zwischen 1000 mm² und 1800 mm² aufweist.

10. Schutzvorrichtung nach einem der Ansprüche 1 bis 9, **dadurch gekennzeichnet, dass** die Erdungsschicht (25), die Kontaktbereiche (29) und die elektrisch leitfähigen Bahnen (23, 24) vorzugsweise aus Kupfer hergestellt sind, das eine Dicke zwischen 100 µm und 150 µm, vorzugsweise zwischen 120 µm und 135 µm aufweist.

11. Telekommunikationsverteilervorrichtung, umfassend
einen Befestigungsrahmen,
mehrere Kontaktstreifen, die in dem Befestigungsrahmen untergebracht sind,
mehrere Schutzvorrichtungen, die in dem Befestigungsrahmen untergebracht sind, wobei jede Schutzvorrichtung mit einem Kontaktstreifen verbunden ist,
**dadurch gekennzeichnet, dass**
mindestens eine Schutzvorrichtung von der Schutzvorrichtung nach einem der Ansprüche 1 bis 10 bereitgestellt ist.

## Revendications

1. Dispositif de protection (10) pour une bande de contact d'un dispositif de distribution de télécommunications comprenant une carte à circuits intégrés (11) et une pluralité d'éléments anti-surcharge (12) montés sur la carte à circuits intégrés (11),
la carte à circuits intégrés (11) fournissant des lames de contact (15) par le biais desquelles le dispositif de protection (10) peut être connecté à des ressorts de contact de la bande de contact, les lames de contact (15) étant disposées côte à côte sous forme d'une pluralité de paires de lames de contact (16) ;
la carte à circuits intégrés (11) fournissant des trous (17, 18, 19) pour recevoir des fils conducteurs (20, 21, 22) des éléments anti-surcharge (12) ;
un élément anti-surcharge (12) étant associé à chaque paire de lames de contact (16), l'élément anti-surcharge (12) respectif étant en contact électrique avec les lames de contact (15) de la paire de lames de contact respective (16),
**caractérisé en ce que**
chaque élément anti-surcharge (12) comprend au moins trois fils conducteurs (20, 21, 22), à savoir un premier et un deuxième fil conducteur (20, 21) qui sont connectés électriquement aux lames de contact (15) de la paire de lames de contact respective (16) et un troisième fil conducteur (22) qui est connecté électriquement à une couche de mise à la terre (25) de la carte à circuits intégrés (11),
des chemins électriquement conducteurs (23, 24) s'étendant entre les lames de contact (15) et des premier et deuxième trous traversants (17, 18) destinés à recevoir les premier et deuxième fils conducteurs (20, 21) des éléments anti-surcharge (12) étant situés sur un premier côté (13) de la carte à circuits intégrés (11) tandis que la couche de mise à la terre (25) est située sur un deuxième côté opposé (26) de la carte à circuits intégrés (11),
au moins le premier et le deuxième fil conducteur (20, 21) de chaque élément anti-surcharge (12) sont courbes, des extrémités courbes des fils conducteurs courbes (20, 21) des éléments anti-surcharge (12) s'étendant sur le deuxième côté (26) de la carte à circuits intégrés (11) parallèlement à un plan défini par la carte à circuits intégrés (11),
l'extrémité courbe de chaque fil conducteur courbe (20, 21) est en contact électrique avec une zone de contact (29) prévue sur le deuxième côté (26) de la carte à circuits intégrés (11), chacune des zones de contact (29) étant séparée de la couche de mise à la terre (25) par une zone isolante (30) entourant la zone de contact respective (29),
les premier et deuxième trous traversants (17, 18) fournissent un contact traversant entre les chemins électriquement conducteurs (23, 24) prévus sur le premier côté (13) de la carte à circuits intégrés (11) et les zones de contact (29) prévues sur le deuxième côté (16) de la carte à circuits intégrés (11).

2. Dispositif de protection selon la revendication 1, **caractérisé en ce que** les chemins électriquement conducteurs (23, 24) fournis par la carte à circuits intégrés (11) s'étendent entre les lames de contact (15) et les premier et deuxième trous traversants (17, 18) de manière à recevoir des premier et deuxième fils conducteurs (20, 21) des éléments anti-surcharge, les chemins électriquement conducteurs (23, 24) qui sont associés à une paire de lames de contact (16) étant en contact électrique l'un avec l'autre lorsque les premier et deuxième fils conducteurs (20, 21) de l'élément anti-surcharge (12) qui sont associés à ladite paire de lames de contact (16) sont reçus à l'intérieur des premier et deuxième trous traversants (17, 18).

3. Dispositif de protection selon la revendication 2, **caractérisé en ce que** les chemins électriquement conducteurs (23, 24) s'étendant entre les lames de contact (15) et les premier et deuxième trous traversants (17, 18) sont situés sur un côté inférieur (13) de la carte à circuits intégrés (11) .

4. Dispositif de protection selon la revendication 3, **caractérisé en ce que** les extrémités courbes des fils conducteurs courbes (20, 21) des éléments anti-surcharge (12) s'étendent sur un côté supérieur (26) de la carte à circuits intégrés (11) parallèlement à un plan défini par la carte à circuits intégrés (11).

5. Dispositif de protection selon l'une quelconque des revendications 2 à 4, **caractérisé en ce que** seulement dans la région des lames de contact (15), les chemins électriquement conducteurs (23, 24) s'étendant entre les lames de contact (15) et les premier et deuxième trous traversants (17, 18) sont situés des deux côtés (13, 16) de la carte à circuits intégrés (11), à savoir de telle sorte que des sections des chemins conducteurs (23, 24) s'étendant sur les côtés opposés des lames de contact (15) soient connectés par des connexions à trous traversants (28).

6. Dispositif de protection selon l'une quelconque des revendications 1 à 5, **caractérisé en ce que** chaque zone de contact (29) présente une surface entre 5 mm² et 12 mm², de préférence entre 5 mm² et 9 mm².

7. Dispositif de protection selon l'une quelconque des revendications 1 à 6, **caractérisé en ce que** chaque zone isolante (30) entourant la zone de contact respective (29) présente une largeur comprise entre 0,8 mm et 2 mm, de préférence entre 1,0 mm et 1,5 mm.

8. Dispositif de protection selon l'une quelconque des revendications 1 à 7, **caractérisé en ce que** chaque zone de section isolante (30) présente une surface comprise entre 10 mm² et 60 mm², de préférence entre 20 mm² et 50 mm².

9. Dispositif de protection selon l'une quelconque des revendications 1 à 8, **caractérisé en ce que** la couche de mise à la terre (25) présente une surface comprise entre 1000 mm² et 2400 mm², de préférence entre 1000 mm² et 1800 mm².

10. Dispositif de protection selon l'une quelconque des revendications 1 à 9, **caractérisé en ce que** la couche de mise à la terre (25), les zones de contact (29) et les chemins électriquement conducteurs (23, 24) sont de préférence fabriqués en cuivre ayant une épaisseur comprise entre 100 µm et 150 µm, de préférence entre 120 µm et 135 µm.

11. Dispositif de distribution de télécommunications, comprenant
un cadre de montage,
une pluralité de bandes de contact reçues dans le cadre de montage,
une pluralité de dispositifs de protection reçus dans le cadre de montage, chaque dispositif de protection étant connecté à une bande de contact,
**caractérisé en ce**
**qu'**au moins un dispositif de protection est prévu sous la forme d'un dispositif de protection selon l'une quelconque des revendications 1 à 10.
